# EUROPEAN PATENT SPECIFICATION

(11) **EP 2 295 846 B1**
(45) Date of publication and mention of the grant of the patent: **15.08.2012**
(21) Application number: 09794238.7
(22) Date of filing: 07.04.2009
(51) Int. Cl.: F21S 2/00, F21V 3/00, F21V 23/00, F21V 29/00, G02F 1/1333, G02F 1/13357, H01L 33/00, F21Y 101/02, G02B 6/00, H05K 7/20

(54) **LIGHTING DEVICE AND LIQUID CRYSTAL DISPLAY DEVICE**
BELEUCHTUNGSVORRICHTUNG UND FLÜSSIGKRISTALLANZEIGEVORRICHTUNG
DISPOSITIF D'ÉCLAIRAGE ET DISPOSITIF D'AFFICHAGE À CRISTAUX LIQUIDES

(30) Priority: 07.07.2008 JP 2008177100
(43) Date of publication of application: 16.03.2011
(73) Proprietor: Sharp Kabushiki Kaisha, Osaka-shi, Osaka 545-8522 (JP)
(72) Inventor: ITOH, Kohji, Osaka-shi, Osaka 545-8522 (JP); SUMINOE, Shinji, Osaka-shi, Osaka 545-8522 (JP); ONOUE, Masato, Osaka-shi, Osaka 545-8522 (JP); TAKEDA, Daisuke, Osaka-shi, Osaka 545-8522 (JP)
(74) Representative: Müller-Boré & Partner Patentanwälte
(86) International application number: PCT/JP2009/057087
(87) International publication number: WO 2010/004791

(56) References cited:
- WO-A1-2009/016853
- WO-A2-00/60406
- JP-A- 8 023 182
- JP-U- 50 073 384

## Description

### Technical Field

The present invention relates a lighting device including a frame set and a light source, the frame set including a mounting board for mounting circuit elements thereon and a frame for supporting the mounting board, and to a liquid crystal display device including the lighting device.

### Background Art

Electronic devices have posed an important challenge in how to dissipate heat from an on-board heat source, such as driving heat of circuit elements. Accordingly, countermeasures against the heat have been taken in various types of electronic devices. For example, as illustrated in FIG. 12, a plasma display device 169 (see Patent Literature 1), in which a frame 111 is interposed between each mounting board 123 for mounting circuit elements (not shown) and a plasma display 159, has the following structure (a set of the mounting board 123 for mounting circuit elements and the frame 111 is referred to also as frame set st).

That is, the frame 111 has a partition wall 171 formed therein to surround the periphery of each mounting board 123, and further the partition wall 171 has heat dissipation grooves 172 formed therein in places on the upper side in the gravity direction. This allows hot air heated by the mounting board 123 to be released to the outside through the heat dissipation grooves 172.

WO 2009/016853 A1 claims priority from 27. July 2007 and has been published on February 05, 2009. WO 2009/016853 A1 discloses an illumination device and a display device using the same. The illumination device includes a plurality of light emitting diodes mounted on a surface of a light source substrate (LED substrate), wherein a row of light emitting diodes is arranged along a predetermined direction. Further, the illumination device includes a plurality of light source substrates, wherein adjacent LED substrates are connected electrically to each other.

WO 00/60406 discloses a device and a method for backlighting a liquid crystal display device using light emitting diodes. The backlighted liquid crystal display device comprises an optical chamber, a liquid crystal device mounted on one of the faces of the optical chamber, a printed circuit board having two essentially parallel surfaces, one of which is mounted on one of the faces of the optical chamber, and a plurality of light emitting diodes arranged in a two-dimensional array across essentially the entirety of the one of the surfaces of the printed circuit board. In an embodiment the backlighted liquid crystal display device comprises further a heat sink adjacent the printed circuit board. Semiconductor chips and brightness control circuit are fitted into a cavity formed in one face of the heat sink.

### Summary of Invention

### Technical Problem

Meanwhile, the heat generated by the circuit elements and the mounting board 123 heats the outside air and is transferred also to the frame 111. As long as the frame 111 has an area wide enough to be brought into contact with the outside air, the heat is dissipated to the outside via the frame 111.

Otherwise if the frame 111 has heat, the circuit elements in the vicinity of the frame 111 are affected by the heat, resulting in a change in circuit characteristics. In particular, if heat distribution in the frame 111 is not uniform, each circuit element is varied in circuit characteristics.

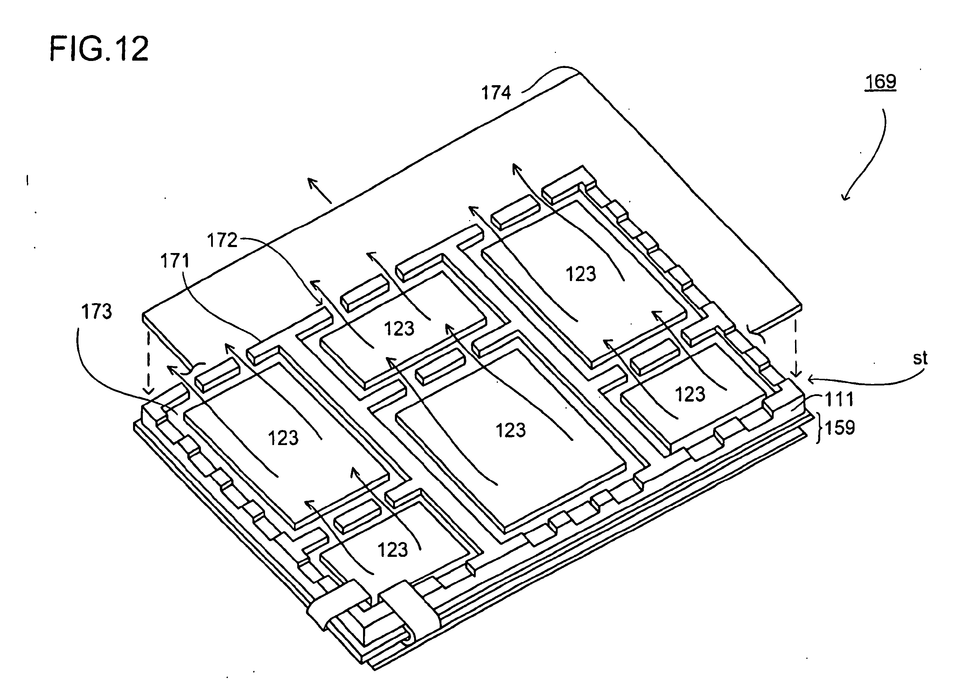

For example, in the case of the frame 111 as illustrated in FIG. 12, the mounting boards 123 are each accommodated in a narrow space which is formed by a bottom surface 173 of the frame 111, the partition wall 171, and a case 174. The hot air filling the narrow space flows out through the heat dissipation grooves 172. Then, due to the flow of hot air, the heat distribution in the frame 111 becomes no longer uniform. Consequently, each circuit element is varied in circuit characteristics.

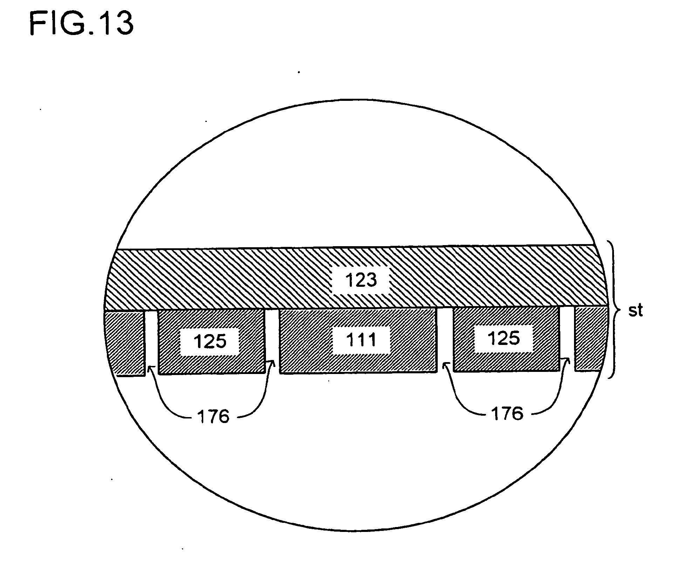

Further, as illustrated in a partial cross-sectional view of FIG. 13, the frame 111 has openings 176 formed therein in some cases, in order to avoid contact between each circuit element 125 as a heat source and the frame 111. In such a frame 111, however, the heat transferred from the mounting board 123 is hindered by the openings 176 and less transferred over a wide area (i.e., the frame 111 is lowered in thermal conductivity). Accordingly, uniform heat distribution in the frame 111 is not obtained, still resulting in different circuit characteristics among the circuit elements 125.

The present invention has been made in view of the above-mentioned circumstances. It is therefore an object of the present invention to provide a frame set and the like, in which a frame has uniform heat distribution while releasing heat remaining in a circuit element and in a mounting board to the frame.

### Solution to Problem

According to an aspect, there is provided a lighting device including frame set and a light source. The frame set includes a mounting board having circuit elements mounted thereon wherein, the surface of the mounting board on which the circuit elements are mounted defines a circuit element mounting surface; and a frame for supporting the mounting board, wherein the light source is mounted on the surface of the mounting board opposite to the circuit element mounting surface. The surface of the frame opposed to the circuit element mounting surface defines an opposing surface, the opposing surface has dents which accommodate the circuit elements, respectively. Further, the surface of the frame opposite to the opposing surface defines a back surface, a bottom part of each of the dents protrudes from a recess part of the back surface, the recess part being recessed with respect to the bottom part of the dents, thereby defining a height difference in the back surface. The back surface of the frame covers a drive board arranged to mount a drive circuit thereon. Wiring of the drive board is accommodated in the recessed space formed by the height difference in the back surface, or a heat conducting member is accommodated in the recessed space formed by the height difference in the back surface while contacting the frame and the drive board.

With this, the circuit element is accommodated in the dent without directly contacting the opposing surface of the frame, and instead, the circuit element mounting surface of the mounting board and the opposing surface of the frame are in contact with each other. Accordingly, in a case where the mounting board has heat due to driving heat of the circuit element, the heat is released from the mounting board to the frame. In other words, the driving heat of the circuit element is released to the frame via the mounting board. Therefore, neither the circuit element nor the mounting board is not degraded by heat.

In particular, the frame includes only the dents, which are not through-openings passing therethrough. Accordingly, the frame is increased in heat dissipation area and heat dissipating performance, as compared with a frame having openings. Besides, the heat transfer in the frame is not hindered by an opening, and hence uniform heat distribution in the frame is obtained, causing no difference in circuit characteristics among the circuit elements due to the influence of heat.

Note that, each of the dents is desired to be brought into contact with at least a part of an outer shape of the circuit element exposed from the circuit element mounting surface.

With this, the driving heat of the circuit elements is transferred to the frame via the dents. In other words, the driving heat of the circuit elements is released directly to the frame.

As indicated above, when defining that, in the frame, one surface on another side of the opposing surface is a back surface, a bottom part of each of the dents protrudes from the back surface while a portion of the back surface not protruding is recessed with respect to the bottom part of the each of the dents, thereby defining a height difference in the back surface.

With this, the height difference in the back surface forms an accommodating space, and the accommodating space may accommodate a separate member.

A heat conducting member may be accommodated in an accommodating space formed by the height difference in the back surface while contacting the frame.

With this, the heat transferred to the frame is released to the heat conducting member, and hence the degradation of the circuit elements and the mounting board due to the heat is further prevented.

Further, in the lighting device including: the frame set in which the accommodating space is formed; and the light source mounted on the surface on the another side of the circuit element mounting surface, the back surface of the frame covers a drive board for mounting a drive circuit thereon, and wiring of the drive board may be accommodated in the accommodating space.

With this, the thickness of a bundle of wiring does not cause a situation where a thickness of a backlight unit increases.

Alternatively, in the lighting device including: the frame set in which the accommodating space is formed; and the light source mounted on the surface on the another side of the circuit element mounting surface, the back surface of the frame covers a drive board for mounting a drive circuit thereon, and a heat conducting member is accommodated in the accommodating space while contacting the frame and the drive board.

With this, in addition to the heat remaining in the light source, the circuit elements, and the mounting board, the drive heat of the drive circuit remaining in the drive board is released to the frame. Therefore, in addition to the light source, the circuit elements, and the mounting board, the drive circuit and the drive board are less apt to be degraded by heat.

Note that, the present invention also encompasses a liquid crystal display device including: the lighting device described above; and a liquid crystal display panel for receiving light from the lighting device.

### Advantageous Effects of Invention

According to the present invention, the frame has no opening which hinders the heat transfer. Accordingly, the heat remaining in the circuit element and the mounting board is released to the frame, and uniform heat distribution is obtained in the frame. Therefore, there is no difference in circuit characteristics among the circuit elements due to the influence of heat. It should be understood that the degradation of the circuit element and the mounting board due to heat is also prevented.

### Brief Description of Drawings

[FIG. 1] FIG. 1 is an exploded perspective view enlarging a part of a liquid crystal display device.
[FIG. 2] FIG. 2 is a perspective view of a mounting board viewed from an LED mounting surface.
[FIG. 3] FIG. 3 is a perspective view of the mounting board viewed from a circuit element mounting surface.
[FIG. 4] FIG. 4 is a perspective view of a backlight frame viewed from an opposing surface.
[FIG. 5] FIG. 5 is a perspective view of the backlight frame viewed from a back surface.
[FIG. 6] FIG. 6 is a perspective view illustrating a manufacturing process for a backlight unit.
[FIG. 7A] FIG. 7A is a partial perspective view of a frame set viewed from the back surface.
[FIG. 7B] FIG. 7B is a perspective view of the backlight frame and circuit elements viewed from the opposing surface, omitting the mounting board.
[FIG. 8] FIG. 8 is a partial cross-sectional view of the liquid crystal display device.
[FIG. 9] FIG. 9 is an exploded perspective view of the liquid crystal display device.
[FIG. 10] FIG. 10 is a cross-sectional view taken along the arrow A-A' of the liquid crystal display device of FIG. 9.
[FIG. 11] FIG. 11 is an exploded perspective view enlarging a part of the liquid crystal display device.
[FIG. 12] FIG. 12 is a perspective view of a conventional plasma display.
[FIG. 13] FIG. 13 is a partial cross-sectional view illustrating a frame including openings and a mounting board supported by the frame.

### Description of Embodiments

### [Embodiment 1]

Referring to the drawings, an embodiment is described as follows. Note that, for convenience' sake, hatching, symbols for members, and the like are omitted in some cases, and in that case, the other drawings shall be referred to. Further, the filled circle in the drawing indicates the vertical direction with respect to the sheet.

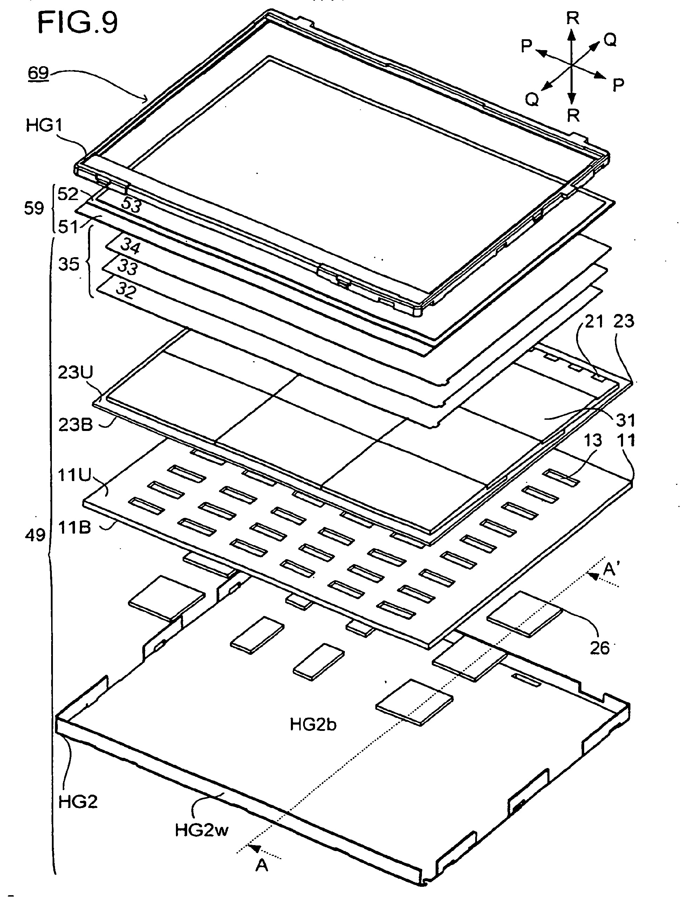

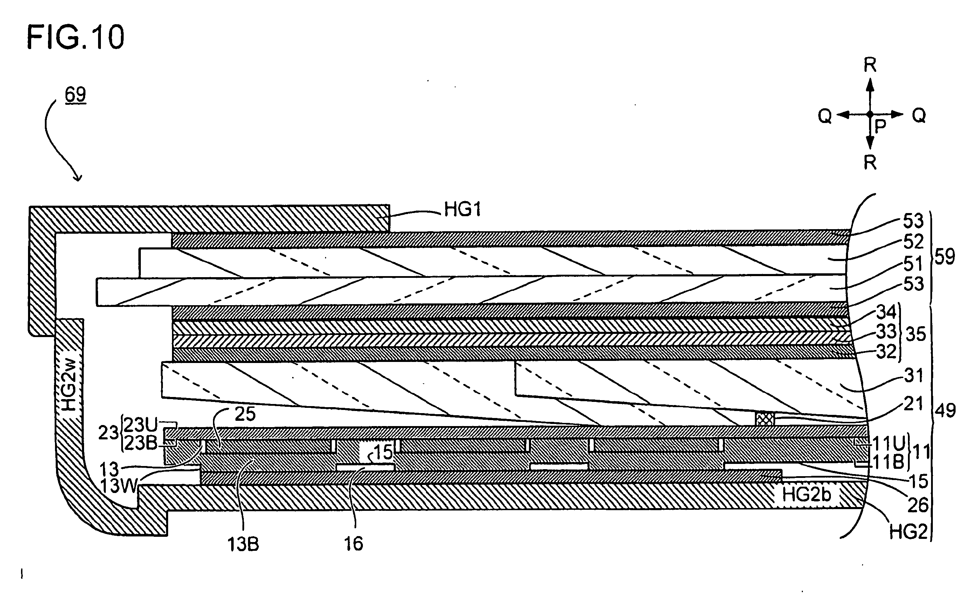

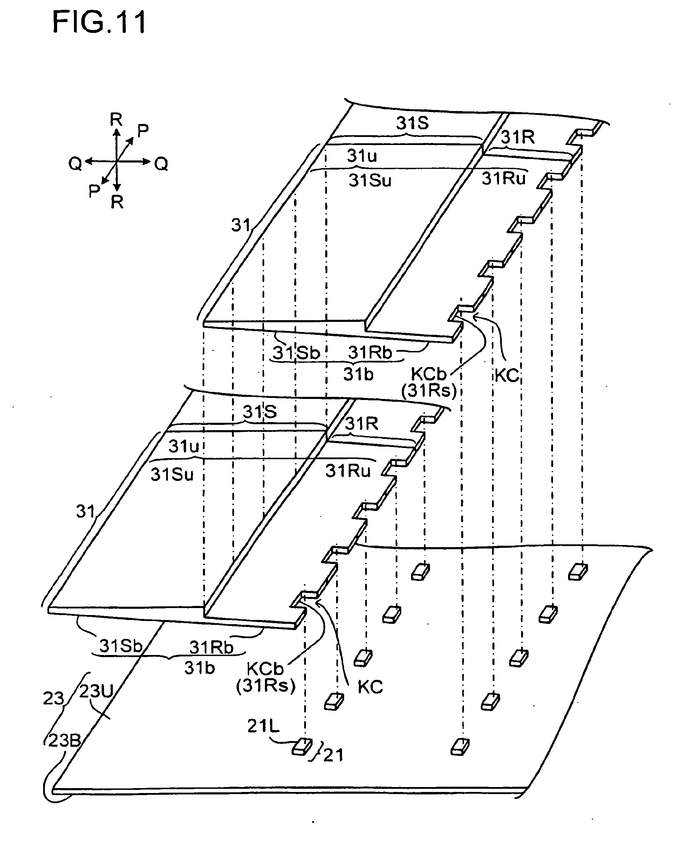

FIG. 9 is an exploded perspective view illustrating a liquid crystal display device (display device) 69, and FIG. 10 is a cross-sectional view taken along the arrow A-A' of the liquid crystal display device 69 of FIG. 9. FIG. 11 is an exploded perspective view enlarging a part of the liquid crystal display device 69.

As illustrated in FIG. 9 and FIG. 10, the liquid crystal display device 69 includes a liquid crystal display panel 59, a backlight unit 49, and housings HG sandwiching the liquid crystal display panel 59 and the backlight unit 49 therebetween (the housing HG covering the liquid crystal display panel 59 is referred to as front housing HG1, while the housing HG supporting the backlight unit 49 is referred to as rear housing HG2).

In the liquid crystal display panel (display panel) 59, an active matrix substrate 51 including switching elements such as thin film transistors (TFTs) and a counter substrate 52 opposed to the active matrix substrate 51 are bonded to each other by a sealing material (not shown). Then, liquid crystal (not shown) is injected into a gap between both the substrates 51 and 52 (polarizing films 53 and 53 may be attached so as to sandwich the active matrix substrate 51 and the counter substrate 52).

The backlight unit (lighting device) 49 illuminates the liquid crystal display panel 59 of non-self-luminous type with light. In other words, the liquid crystal display panel 59 exhibits a display function when receiving the light (backlight) from the backlight unit 49. Accordingly, if uniform illumination of the entire surface of the liquid crystal display panel 59 is attained by the light from the backlight unit 49, display quality of the liquid crystal display panel 59 is improved.

Then, the backlight unit 49 described above includes light emitting diodes (LEDs) 21, a mounting board 23, light guide members 31, a diffusion sheet 32, optical sheets 33 and 34, and a backlight frame 11.

As illustrated in the enlarged exploded perspective view of FIG. 11, the LEDs 21 are light emitting elements (light sources) that emit light and are mounted onto electrodes (not shown) formed on a substrate surface of the mounting board 23, so that the LEDs 21 are supplied with a current from a power source (not shown). Note that, in the mounting board 23, the substrate surface on which the LEDs 21 are mounted via the electrodes is referred to as LED mounting surface 23U (the LED mounting surface 23U is also a surface on the other side of a circuit element mounting surface 23B to be described later).

For ensuring the amount of light, a plurality of the LEDs (point light sources) 21 should be mounted on the mounting board 23 and are desired to be arranged in parallel in a row. It should be noted that, for convenience' sake, the drawings illustrate only a part of the LEDs 21 (hereinafter, the direction in which the largest number of the LEDs 21 are arranged is referred to as arrangement direction P).

The light guide member 31 allows light of the LEDs 21 entering itself to be subjected to multiple reflection (mixing) and outputs the light to the outside. As illustrated in FIG. 11, the light guide members 31 each include a receiving piece 31R that receives light and an output piece 31S connecting to the receiving piece 31R.

The receiving piece 31R is a plate-shaped member and has notches (main notches) KC as part of its side wall along the arrangement direction P. The notch KC has a space large enough to surround the LED 21 while opposing its own bottom KCb to a light emitting surface 21L of the LED 21. Accordingly, when the LED 21 is attached so as to be accommodated in the notch KC, the bottom KCb of the notch KC becomes a light receiving surface 31Rs of the light guide member 31. Note that, out of the two surfaces sandwiching the side wall of the receiving piece 31R, a surface facing toward the mounting board 23 (rear housing HG2 by extension) is referred to as bottom surface 31Rb, and an opposite surface of the bottom surface 31Rb is referred to as top surface (output surface) 31Ru.

The output piece 31S is a plate-shaped member communicating to the receiving piece 31R side by side and positioned in the travel destination of light that has entered from the light receiving surface 31Rs. The output piece 31S has a bottom surface 31Sb that is coplanar (flush) with the bottom surface 31Rb of the receiving piece 31R. The output piece 31S also has a top surface (output surface) 31Su that defines a step so as to be larger in height than the top surface 31Ru of the receiving piece 31R.

Further, the top surface 31Su and the bottom surface 31Sb of the output piece 31S are not parallel to each other, but one of those surfaces is inclined with respect to the other surface. Specifically, as being closer to the travel destination of light from the light receiving surface 31Rs, the bottom surface 31Sb is inclined toward the top surface 31Su. In other words, as being closer to the travel destination of light from the light receiving surface 31Rs, the output piece 31S is gradually reduced in thickness (interval between the top surface 31Su and the bottom surface 31Sb) to be tapered (the light guide member 31 including the thus tapered output piece 31S is referred to also as wedge-shaped light guide member 31).

Then, the light guide member 31 including the receiving piece 31R and the output piece 31S described above receives light from the light receiving surface 31Rs, mixes the light between the bottom surface 31b (31Rb, 31Sb) and the top surface 31u (31Ru, 31Su), and outputs the resultant light to the outside from the top surface 31Su (the light to be output from the top surface 31Su is referred to as planar light).

The light guide members 31 described above are arranged in a row on the mounting board 23 so as to correspond to the LEDs 21 arranged in a row (along the arrangement direction P). Further, the light guide members 31 in a row are arranged in an intersecting direction Q intersecting the arrangement direction P (for example, a direction orthogonal to the arrangement direction P). The light guide members 31 are thus arranged in matrix.

In particular, in such arrangement of the light guide members 31 along the intersecting direction Q, the top surface 31Ru of the receiving piece 31R supports the bottom surface 31Sb of the output piece 31S alternately so that a coplanar surface is completed by the top surfaces 31Su thus gathered (the top surfaces 31Su are gathered as being flush with one another). Similarly, in another arrangement of the light guide members 31 along the arrangement direction P, the top surfaces 31Su are gathered to complete a coplanar surface. As a result, the top surfaces 31Su of the light guide members 31 are arranged in matrix to become a relatively large light output surface (the light guide members 31 which are arranged in matrix as described above are referred to also as tandem type light guide members 31).

The diffusion sheet 32 is positioned to cover the top surfaces 31Su of the gathered light guide members 31, and diffuses the planar light from the light guide members 31, allowing the light to spread over the entire region of the liquid crystal display panel 59 (the diffusion sheet 32 and the optical sheets 33 and 34 are collectively referred to also as optical sheet group 35).

The optical sheet 33 is an optical sheet for narrowing the directivity of light, which has a prism shape in the sheet plane, for example, and is positioned to cover the diffusion sheet 32. Accordingly, the optical sheet 33 collects light traveling from the diffusion sheet 32 and thereby enhances brightness.

The optical sheet 34 is an optical sheet positioned to cover the optical sheet 33, for transmitting a polarizing component in a given direction and reflecting a polarizing component orthogonal to the transmitted polarizing component. Then, the optical sheet 34 reflects and reuses a polarizing component which is otherwise absorbed by a polarizing film 43, to thereby enhance brightness of the liquid crystal panel 49.

The backlight frame (frame) 11 is a plate-shaped frame for supporting the LEDs 21, the mounting board 23, the light guide members 31, the diffusion sheet 33, and the optical sheets 33 and 34 described above (the material of the backlight frame 11 is not particularly limited and may be any of a metal and a resin; aluminum with 2 mm in thickness is used herein). Note that, the details of the backlight frame 11 are described later.

The rear housing HG2 is a housing for housing the LEDs 21, the mounting board 23, the light guide members 31, the diffusion sheet 33, the optical sheets 33 and 34, and the backlight frame 11 described above. The shape of the rear housing HG2 is not particularly limited and may be, for example, as illustrated in FIG. 9 and FIG. 10, a box having a bottom surface (support surface) HG2b and a wall portion HG2w erected from the bottom surface HG2b, and may have other shapes. Besides, the material of the rear housing HG2 is not particularly limited, either.

Note that, the rear housing HG2 houses the above-mentioned members in such a manner that the mounting board 23 is laid on top of the backlight frame 11 and the optical sheet group 35 is laid on top of the top surfaces 31Su of the light guide members 31, which are positioned on the mounting board 23 and arranged in matrix. Here, the direction in which those members are stacked is referred to as stacking direction R (the arrangement direction P, the intersecting direction Q, and the stacking direction R may have an orthogonal relationship thereamong).

Further, from the viewpoint that the rear housing HG2 houses various kinds of members constituting the backlight unit 49, the rear housing HG2 is regarded as one part of the backlight unit 49. The rear housing HG2 houses various kinds of boards as well as the mounting board 23. For example, as illustrated in FIG. 9 and FIG. 10, drive boards 26 having various drive circuits mounted thereon are placed on the bottom surface HG2b of the rear housing HG2 so as to be covered by the backlight frame 11.

The front housing HG1 is a frame-shaped member and covers the rear housing HG2 while holding down various kinds of members housed in the rear housing HG2. The front housing HG1 is then fixed by the rear housing HG2 (the way of fixation is not limited). Thus, the front housing HG1 sandwiches the backlight unit 49 and the liquid crystal display panel 59 together with the rear housing HG2, completing the liquid crystal display device 69.

Then, in the liquid crystal display device 69 described above, the light of the LEDs 21 is output after being converted into planar light by the light guide members 31, and the planar light passes through the optical sheet group 35 to be output as backlight, which is increased in emission brightness. Further, the backlight reaches the liquid crystal display panel 59, allowing the liquid crystal display panel 59 to display an image.

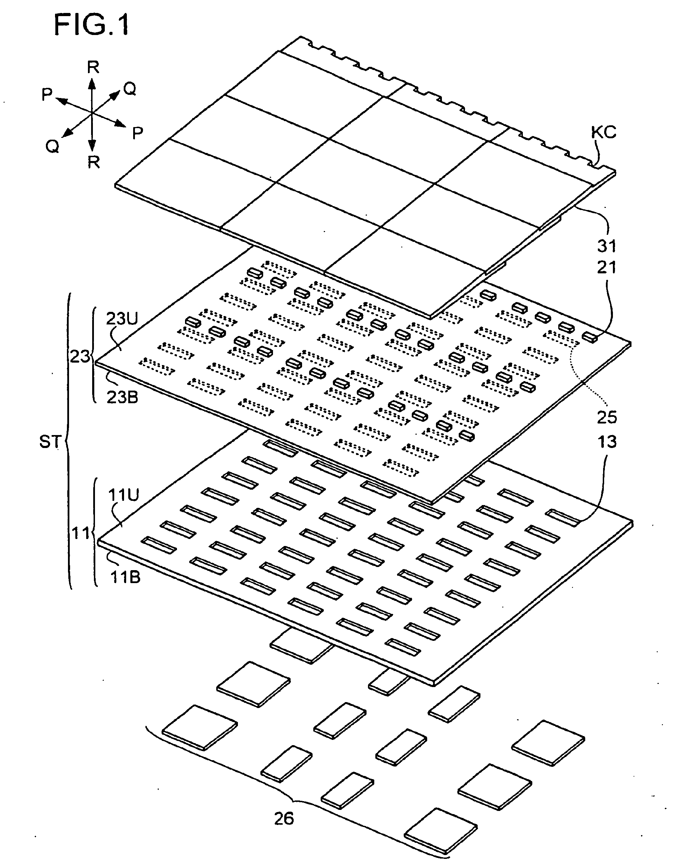

Now, the mounting board 23 for mounting the LEDs 21 and circuit elements 25, and the backlight frame 11 are described in detail with reference to FIGS. 1 to 8 (a set of the mounting board 23 for mounting the circuit elements 25 and the backlight frame 11 for supporting the mounting board 23 is referred to also as frame set ST).

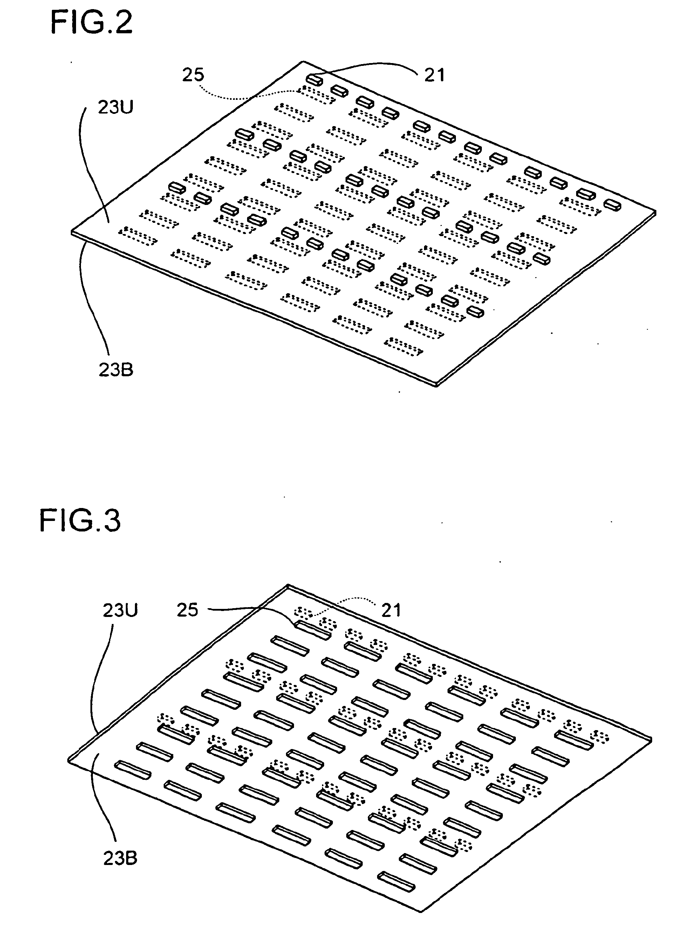

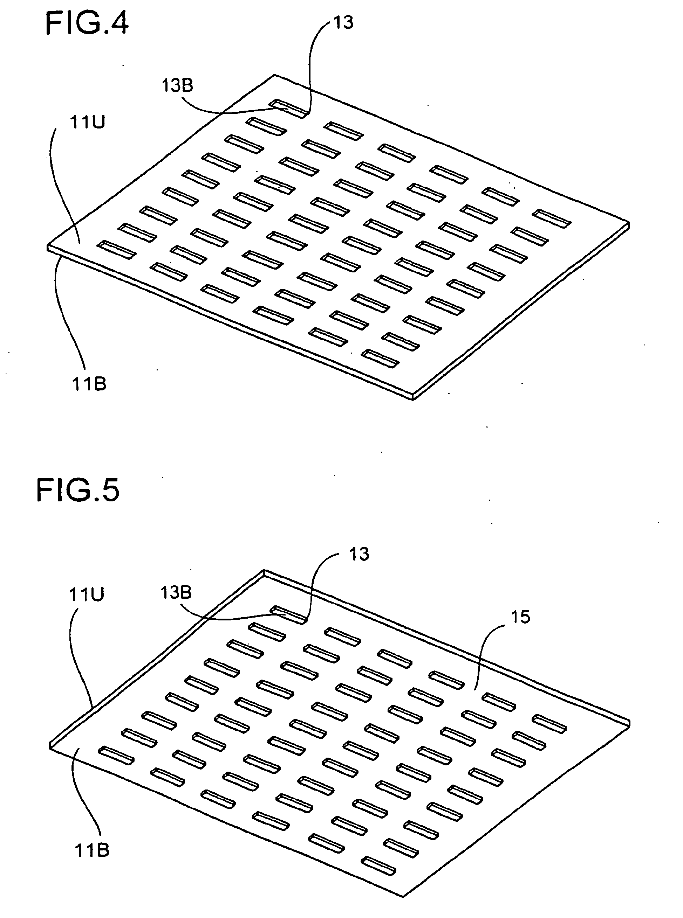

FIG. 1 is an exploded perspective view enlarging a part of the liquid crystal display device 69. FIG. 2 is a perspective view of the mounting board 23 viewed from the LED mounting surface 23U, and FIG. 3 is a perspective view of the mounting board 23 viewed from the other side of the LED mounting surface 23U (from the circuit element mounting surface 23B to be described later). FIG. 4 is a perspective view of the backlight frame 11 viewed from one surface 11U of the two surfaces opposed to each other, and FIG. 5 is a perspective view of the backlight frame 11 viewed from another surface 11B on the other side of the one surface 11U.

As illustrated in FIG. 2 and FIG. 3, on the LED mounting surface 23U of the mounting board 23, the plurality of LEDs 21 are mounted so as to correspond to the plurality of notches KC of the light guide members 31. On the other hand, as illustrated in FIG. 3, on the substrate surface 23B as the surface on the other side of the LED mounting surface 23U, various kinds of circuit elements 25 other than the LEDs 21, such as the plurality of circuit elements 25 for driving the LEDs 21, are mounted. Therefore, the substrate surface 23B is referred to as circuit element mounting surface 23B.

As illustrated in FIG. 1, the backlight frame 11 is covered by the mounting board 23 (the backlight frame 11 and the mounting board 23 have substantially the same area). Specifically, the circuit element mounting surface 23B of the mounting board 23 covers the one surface 11U of the two surfaces 11U and 11B of the backlight frame 11. This way, the one surface (opposing surface) 11U is also opposed to the circuit elements 25 positioned on the circuit element mounting surface 23B.

However, the circuit elements 25 thus mounted protrude from the circuit element mounting surface 23B. Accordingly, if left as they are, the circuit element mounting surface 23B of the mounting board 23 and the opposing surface 11U of the backlight frame 11 are not brought into direct contact with each other, and the contact is made between the circuit elements 25 and the opposing surface 11U instead.

Accordingly, as illustrated in FIG. 4 and FIG. 5, accommodating spots (dents) 13, which are recessed from the opposing surface 11U, are formed in the backlight frame 11 so as to correspond to the circuit elements 25, respectively. Specifically, the accommodating spot 13 is a dent having the volume large enough to accommodate the whole of the circuit element 25 exposed from the circuit element mounting surface 23B (FIG. 5 is a perspective view of the backlight frame 11 viewed from the back surface 11B as the surface on the other side of the opposing surface 11U).

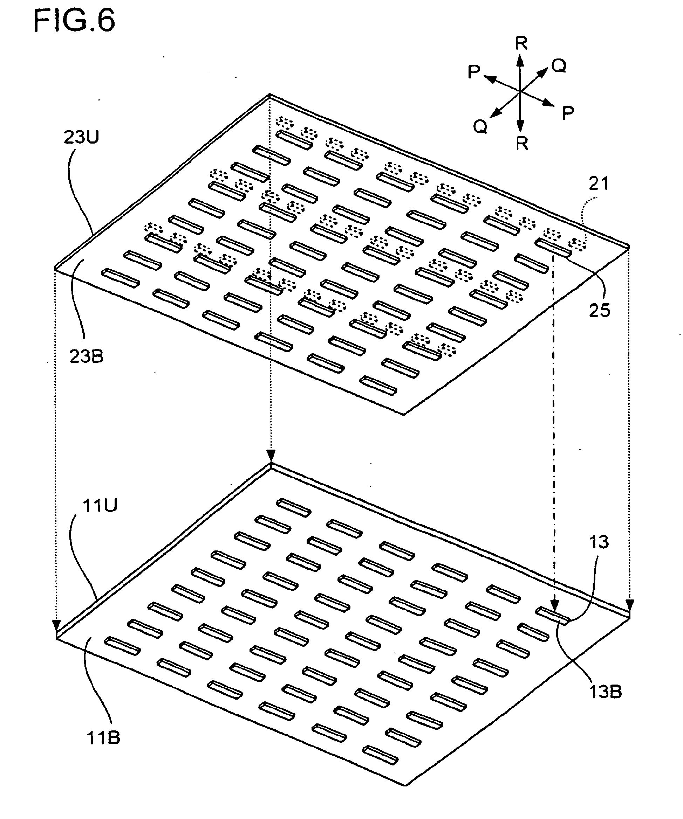

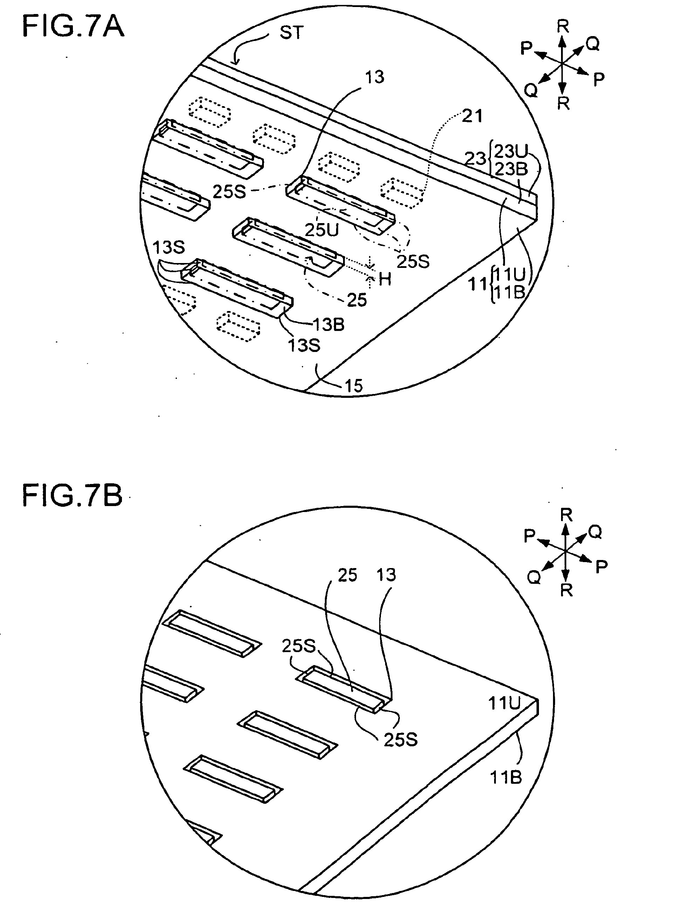

Then, in manufacturing the backlight unit 49, as illustrated in FIG. 6, the mounting board 23 covers the opposing surface 11U of the backlight frame 11 with its circuit element mounting surface 23B facing the opposing surface 11U. The following can be seen from FIG. 7A and FIG. 7B (FIG. 7A is a partial perspective view of the frame set ST viewed from the back surface 11B, and FIG. 7B is a perspective view of the backlight frame 11 and the circuit elements 25 viewed from the opposing surface 11U, omitting the mounting board 23).

That is, as illustrated in FIG. 7A and FIG. 7B, the circuit elements 25 are each accommodated in the accommodating spot 13 without directly contacting the opposing surface 11U of the backlight frame 11, and instead, the circuit element mounting surface 23B of the mounting board 23 and the opposing surface 11U of the backlight frame 11 are in contact with each other. With this, in a case where the mounting board 23 has heat due to the driving heat of the circuit elements 25 and the LEDs 21, the heat is transferred from the mounting board 23 to the backlight frame 11.

In other words, heat remaining in the mounting board 23 is dissipated, and further the driving heat of the LEDs 21 and the circuit elements 25 is also released via the mounting board 23 and the backlight frame 11. As a result, the mounting board 23, the LEDs 21, and the circuit elements 25 are less apt to be degraded by heat.

In particular, the backlight frame 11 includes the accommodating spots 13, which are not through-openings passing from the opposing surface 11U to the back surface 11B. Accordingly, the backlight frame 11 is increased in heat dissipation area and heat dissipating performance, as compared with a backlight frame having openings.

Further, in the case where the backlight frame 11 has noopening, heat transfer is not hindered by an opening. Accordingly, the backlight frame 11 without an opening makes the transferring heat uniform in the entire surface {i.e., the backlight frame 11 in which heat is carried on uniformly (heat distribution is uniform) is obtained)}. Therefore, a substantially constant environment temperature is obtained for the plurality of circuit elements 25, causing no difference in temperature influence among the circuit elements 25, to thereby obtain stable circuit characteristics among the circuit elements 25.

Similarly, a substantially constant environment temperature is obtained for the plurality of LEDs 21, causing no difference in temperature influence among the LEDs 21, to thereby obtain substantially equal and stable emission brightness among the LEDs 21. Therefore, no brightness unevenness occurs in the output light from the backlight unit 49.

Further, the accommodating spot 13 is formed so as to correspond to each circuit element 25, and hence the heat dissipation area is increased as compared with, for example, a backlight frame including an accommodating groove for accommodating the plurality of circuit elements 25 together. Therefore, the backlight frame 11 is significantly increased in heat dissipating performance.

Besides, because the accommodating spots 13 are present in the plate-shaped backlight frame 11, this backlight frame 11 is increased in strength as compared with a backlight frame 11 without the accommodating spot 13. Therefore, the backlight frame 11 supports the mounting board 23 and the like in a stable state.

Note that, the accommodating spot 13 is desired to be brought into contact with at least a part of the outer shape of the circuit element 25 exposed from the circuit element mounting surface 23B, that is, at least a part of a top surface 25U of the circuit element 25 (surface not in contact with the circuit element mounting surface 23B) and its side surface 25S surrounding the top surface 25U.

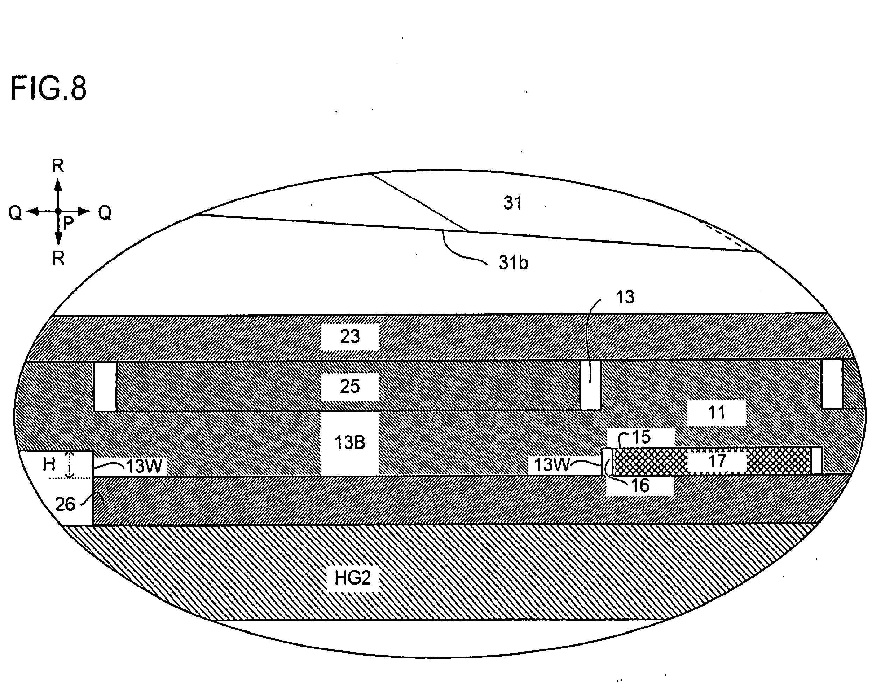

For example, as illustrated in FIG. 8 and FIG. 10, when the top surface 25U of the circuit element 25 is in contact with a bottom part 13B of the accommodating spot 13 (specifically, the bottom part 13B inside the accommodating spot 13), the driving heat of the circuit element 25 is directly transferred to the backlight frame 11. Therefore, the driving heat of the circuit element 25 is reliably released via the backlight frame 11, thereby preventing the degradation of the circuit element 25.

However, it is not always necessary for the accommodating spot 13 to be brought into contact with at least a part of the outer shape of the circuit element 25. In other words, the accommodating spot 13 may be in no contact at all with the outer shape of the circuit element 25. This is because, even in this case, the driving heat of the circuit element 25 is released to the backlight frame 11 via the air interposed in a gap between the accommodating spot 13 and the circuit element 25.

By the way, the accommodating spot 13 in the backlight frame 11 has the bottom part 13B. Then, the bottom part 13B protrudes from the back surface 11B of the backlight frame 11. Accordingly, a portion of the backlight frame 11 which does not protrude from the back surface 11B (portion of the back surface 11B which is not overlapped with the accommodating spot 13; a recess part 15) is recessed with respect to the bottom part 13B of the accommodating spot 13. Accordingly, the back surface 11B has a height difference H between the bottom part 13B (specifically, the bottom part 13B exposed from the back surface 11B) of each accommodating spot 13 and the recess part 15 (see FIG. 7A).

A space 16 (see FIG. 10) defined by the height difference H, that is, a space 16 surrounded by the recess part 15 and an outer wall 13W of the accommodating spot 13 (wall part of the accommodating spot 13 exposed from the back surface 11B), is an accommodating space 16 capable of accommodating a separate member. Then, as illustrated in the partial cross-sectional view of FIG. 8, it is possible to accommodate a heat conducting member 17 in the accommodating space 16. Specifically, it is possible to attach to the recess part 15 a heat conducting member (heat dissipating member) 17 having a thickness smaller than the height (height difference H) between the recess part 15 and the bottom part 13B.

With this, the heat transferred to the backlight frame 11 is released to the heat conducting member 17, which is in contact with the backlight frame 11, and hence the degradation of the LEDs 21, the circuit elements 25, and the mounting board 23 is further prevented. In addition, the thickness of the heat conducting member 17 does not exceed the height (height difference H) between the recess part 15 and the bottom part 13B of the accommodating spot 13, and hence the presence of the heat conducting member 17 does not lead to the increase in thickness of the frame set ST (backlight unit 49 by extension).

Note that, the backlight unit 49 (liquid crystal display device 69 by extension) requires various drive circuits (not shown) as well as the circuit elements 25. Such a drive circuit is, as illustrated in FIG. 1, mounted on the drive board 26 and installed in the backlight unit 49. Then, wiring (not shown) is attached to the drive boards 26.

Here, when the back surface 11B of the backlight frame 11 covers the drive boards 26, the wiring of the drive boards 26 is desired to be accommodated in the accommodating space 16. With this, the thickness of a bundle of wiring does not cause a situation where the thickness of the backlight unit 49 increases.

Note that, what is accommodated in the accommodating space 16 may be other than the wiring of the drive board 26. For example, an available member to be accommodated is the above-mentioned heat conducting member 17. However, if the heat conducting member 17 is installed in the backlight unit 49 together with the drive board 26, the following is desired.

That is, as illustrated in FIG. 8, the heat conducting member 17 is desired to be in contact with the recess part 15 of the backlight frame 11 and also in contact with the drive board 26.

With this, the driving heat of the drive circuit remaining in the drive board 26 is also released to the backlight frame 11, in addition to the heat remaining in the LEDs 21, the circuit elements 25, and the mounting board 23. Therefore, in addition to the LEDs 21, the circuit elements 25, and the mounting board 23, the drive circuits and the drive boards 26 are less apt to be degraded by heat.

### [Other Embodiments]

Note that, the present invention is not limited to the above-mentioned embodiment, and various modifications can be made without departing from the scope of the present invention.

For example, the above description exemplifies the backlight unit 49 of tandem type, in which the plurality of wedge-shaped light guide members 31 are laid in matrix and installed. Here, this backlight unit 49 of tandem type may control the output light for each light guide member 31, whose light amount control system may define the backlight unit 49 to be also a backlight unit 49 of active area type.

Specifically, in the backlight unit 49 of active area type, the liquid crystal display panel 59 is divided into a plurality of display areas so that the divided display areas correspond to the respective light guide members 31, and the respective light guide members 31 illuminate the corresponding divided display areas with light.

Then, the backlight unit 49 described above illuminates independently the divided display areas necessary in the liquid crystal display panel 59, and hence power consumption is suppressed as compared with a backlight unit that illuminates the entire area of the liquid crystal display panel 59 at a time. Besides, the amount of light is varied in each divided display area, resulting in multi-level of display gradation of the liquid crystal display panel 59 (high-quality image display is possible).

Further, in a case where the backlight unit 49 of active area type is designed to be reduced in thickness, the backlight unit 49 of tandem type is more advantageous than a so-called direct type backlight unit (backlight unit having installed therein the LEDs 21 that emit light substantially perpendicular to the in-plane direction of the liquid crystal display panel 59).

In the general direct type backlight unit, the light guide member 31 is omitted and light of the LEDs 21 enters the optical sheet group 35 directly. In this case, unless the light is diffused to some extent before reaching the optical sheet group 35, the light contains brightness unevenness (or color mixing unevenness) when being output via the optical sheet group 35.

Accordingly, a relatively large interval is required between the LEDs 21 and the optical sheet group 35 for light diffusion (i. e. a long optical path length is required). Therefore, the direct type backlight unit is not suitable for a thin backlight unit of active area type.

In the case of the backlight unit 49 of tandem type, however, light of the LEDs 21 enters the side wall of the light guide member 31 (specifically, the receiving piece 53R) in the direction parallel to the in-plane direction of the liquid crystal display panel 59, and is then subjectedtomultiple reflection inside the light guide member 31, resulting in a relatively large optical path length. Then, the following is concluded, when defining that the thickness of the light guide member 31 in the backlight unit 49 of tandem type is smaller than the interval between the LEDs 21 and the optical sheet group 35 of the direct type backlight unit.

That is, the backlight unit 49 of tandem type prevents the brightness unevenness by ensuring the optical path length and also suppresses the increase in thickness comparatively. Besides, the liquid crystal display device 69 having the backlight unit 49 installed therein is capable of providing a high quality image while being thinned. Therefore, in order to obtain a thin backlight unit 49 of active area type, it is significantly effective to arrange the wedge-shaped light guide members 31 in tandem.

However, the thin backlight unit 49 of active area type, which has a large number of LEDs 21 installed therein as the backlight unit 49 of tandem type, is liable to have a large number of members (heat sources) that dissipate the driving heat of the LEDs 21, including the circuit elements 25 and the drive boards 26. Then, for such a backlight unit 49, the above-mentioned frame set ST (set of the mounting boards 23 for mounting the circuit elements 25 and the backlight frame 11), which is high in heat dissipating performance, is significantly effective.

However, the frame set ST is, of course, effective to a backlight unit of other type, and also effective, not limited to the backlight unit, to other electronic devices. For example, the frame set ST is effective also to a display device such as an organic electro-luminescence (EL) display device and a plasma display device (the frame set ST is also effective, not limited to the display device, to other electronic devices).

Further, in the above, the LED 21 is exemplified as a light source, but the light source is not limited thereto. For example, the light source may be a linear light source such as a fluorescent tube or may be formed of a self-luminous material such as an organic EL material and an inorganic EL material.

### Reference Signs List

- 11: backlight frame (frame)
- 11U: opposing surface of backlight frame
- 11B: back surface of backlight frame
- 13: accommodating spot (dent)
- 13B: bottom part of accommodating spot
- 13W: outer wall of accommodating spot
- 15: recess part (portion of back surface of backlight frame with small height difference)
- 16: accommodating space
- H: height difference
- 17: heat conducting member
- 21: LED (light source)
- 23: mounting board
- 23U: LED mounting surface (surface on the other side of circuit element mounting surface)
- 23B: circuit element mounting surface
- 25: circuit element
- 26: drive board
- ST: frame set
- 31: light guide member
- 31R: receiving piece
- 31Ru: top surface of receiving piece
- 31Rb: bottom surface of receiving piece
- 31S: output piece
- 31Su: top surface of output piece
- 31Sb: bottom surface of output piece
- 32: diffusion sheet
- 33: optical sheet
- 34: optical sheet
- 35: optical sheet group
- 49: backlight unit (lighting device)
- 59: liquid crystal display panel (display panel)
- HG1: front housing
- HG2: rear housing
- 69: liquid crystal display device (display device, electronic device)

## Claims

1. A lighting device (49) including a frame set (ST) and a light source (21), wherein the frame set (ST) includes:
a mounting board (23) having circuit elements (25) mounted thereon, wherein the surface of the mounting board (23) on which the circuit elements (25) are mounted defines a circuit element mounting surface (23B); and
a frame (11) arranged to support the mounting board (23), wherein the light source (21) is mounted on the surface (23U) of the mounting board (23) opposite to the circuit element mounting surface (23B),
wherein:
the surface of the frame (11) opposed to the circuit element mounting surface (23B) defines an opposing surface (11 U), the opposing surface (11 U) has dents (13) which accommodate the circuit elements (25), respectively,
the surface of the frame (11) opposite to the opposing surface (11U) defines a back surface (11 B), a bottom part (13B) of each of the dents (13) protrudes from a recess part (15) of the back surface (11 B), the recess part (15) being recessed with respect to the bottom part (13B) of the dents (13), thereby defining a height difference (H) in the back surface (11B),
the back surface (11 B) of the frame (11) covers a drive board (26) arranged to mount a drive circuit thereon, and
wiring of the drive board (26) is accommodated in the recessed space (16) formed by the height difference (H) in the back surface (11 B), or a heat conducting member (17) is accommodated in the recessed space (16) formed by the height difference (H) in the back surface (11 B) while contacting the frame (11) and the drive board (26).

2. A lighting device (49) according to claim 1, wherein each of the dents (13). is in contact with at least a part of the outer shape of a respective circuit element (25) exposed on the circuit element mounting surface (23U).

3. A liquid crystal display device (69), comprising:
the lighting device (49) according to claim 1 or 2; and
a liquid crystal display panel (59) arranged to receive light from the lighting device (49).

## Patentansprüche

1. Beleuchtungsvorrichtung (49), enthaltend einen Rahmensatz (ST) und eine Lichtquelle (21), wobei der Rahmensatz (ST) enthält:
eine Montageplatte (23) mit daran bzw. darauf montierten Schaltungselementen (25), wobei die Fläche bzw. Oberfläche der Montageplatte (23), an bzw. auf der die Schaltungselemente (25) montiert sind, eine Schaltungselementmontagefläche bzw. -oberfläche (23B) definiert; und
einen Rahmen (11), der angeordnet ist, um die Montageplatte (23) zu stützten bzw. zu tragen, wobei die Lichtquelle (21) an bzw. auf der Fläche bzw. Oberfläche (23U) der Montageplatte (23) entgegengesetzt zu der Schaltungselementmontagefläche bzw. -oberfläche (23B) montiert ist,
wobei:
die Fläche bzw. Oberfläche des Rahmens (11) gegenüberliegend zu der Schaltungselementmontagefläche bzw. -oberfläche (23B) eine gegenüberliegende Fläche bzw. Oberfläche (11 U) definiert, wobei die gegenüberliegende Fläche bzw. Oberfläche (11 U) Einbuchtungen (13) aufweist, die jeweils die Schaltungselemente (25) aufnehmen bzw. beherbergen,
die Fläche bzw. Oberfläche des Rahmens (11) entgegengesetzt zu der gegenüberliegenden Fläche bzw. Oberfläche (11U) eine Rückfläche bzw. -oberfläche (11B) definiert, ein Bodenteil (13B) jeder der Einbuchtungen (13) von einem Aussparungsteil (15) der Rückfläche bzw. -oberfläche (11 B) vorragt, wobei der Aussparungsteil (15) bezüglich des Bodenteils (13B) der Einbuchtungen (13) ausgespart ist, wodurch ein Höhenunterschied (H) in der Rückfläche bzw. -oberfläche (11 B) definiert ist,
die Rückfläche bzw. -oberfläche (11B) des Rahmens (11) eine Treiber- bzw. Ansteuerplatte (26) abdeckt, die angeordnet ist, um eine Treiber- bzw. Ansteuerschaltung daran bzw. darauf zu montieren, und
eine Verdrahtung der Treiber- bzw. Ansteuerplatte (26) in dem ausgesparten Raum (16) aufgenommen bzw. beherbergt ist, der durch den Höhenunterschied (H) in der Rückfläche bzw. -oberfläche (11 B) gebildet ist, oder ein Wärmeleitglied (17) in dem ausgesparten Raum (16) aufgenommen bzw. beherbergt ist, der durch den Höhenunterschied (H) in der Rückfläche bzw. - oberfläche (11B) gebildet ist, während sie bzw. es den Rahmen (11) und die Treiber- bzw. Ansteuerplatte (26) kontaktiert.

2. Beleuchtungsvorrichtung (49) nach Anspruch 1, wobei jede der Einbuchtungen (13) mit zumindest einem Teil der äußeren Form eines jeweiligen Schaltungselements (25) in Kontakt ist, das an bzw. auf der Schaltungselementmontagefläche bzw. -oberfläche (23U) freigelegt ist.

3. Flüssigkristallanzeigevorrichtung (69), umfassend:
die Beleuchtungsvorrichtung (49) nach Anspruch 1 oder 2; und
eine Flüssigkristallanzeigetafel bzw. -feld (59), die bzw. das angeordnet ist, um Licht von der Beleuchtungsvorrichtung (49) zu empfangen.

## Revendications

1. Dispositif d'éclairage (49) incluant un ensemble de cadre (ST) et une source lumineuse (21), dans lequel l'ensemble de cadre (ST) inclut :
une carte de montage (23) ayant des éléments de circuit (25) montées sur elle, dans lequel la surface de la carte de montage (23) sur laquelle les éléments de circuit (25) sont montés définit une surface de montage d'élément de circuit (23B) ; et
un cadre (11) agencé pour supporter la carte de montage (23), dans lequel la source lumineuse (21) est montée sur la surface (23U) de la carte de montage (23) opposée à la surface de montage d'élément de circuit (23B),
dans lequel :
la surface du cadre (11) opposée à la surface de montage d'élément de circuit (23B) définit une surface opposée (11U), la surface opposée (11U) possède des creux (13) qui reçoivent les éléments de circuit (25), respectivement,
la surface du cadre (11) opposée à la surface opposée (11U) définit une surface arrière (11B), une partie inférieure (13B) de chacun des creux (13) fait saillie depuis une partie de retrait (15) de la surface arrière (11B), la partie de retrait (15) étant en retrait par rapport à la partie inférieure (13B) des creux (13), définissant de ce fait une différence de hauteur (H) dans la surface arrière (11B), la surface arrière (11B) du cadre (11) recouvre une carte d'entraînement (26) agencée pour monter un circuit d'entraînement sur elle, et
le câblage de la carte d'entraînement (26) est reçu dans l'espace en retrait (16) formé par la différence de hauteur (H) dans la surface arrière (11B), ou
un élément thermoconducteur (17) est reçu dans l'espace en retrait (16) formé par la différence de hauteur (H) dans la surface arrière (11B) tout en mettant en contact le cadre (11) et la carte d'entraînement (26).

2. Dispositif d'éclairage (49) selon la revendication 1, dans lequel chacun des creux (13) est en contact avec au moins une partie de la forme externe d'un élément de circuit respectif (25) exposé sur la surface de montage d'élément de circuit (23U).

3. Dispositif d'affichage à cristaux liquides (69) comprenant :
le dispositif d'éclairage (49) selon la revendication 1 ou 2 ; et
un panneau d'affichage à cristaux liquides (59) agencé pour recevoir de la lumière provenant du dispositif d'éclairage (49).
